# EUROPÄISCHE PATENTANMELDUNG

(11) **EP 2 772 997 A1**
(43) Veröffentlichungstag der Anmeldung: **03.09.2014**
(21) Anmeldenummer: 13157158.0
(22) Anmeldetag: 28.02.2013
(51) Int. Cl.: H01S 5/022, H01S 5/024, H01S 5/40

(54) **Laserdiodenbauelement und Verfahren zu dessen Herstellung**

(71) Anmelder: PBC Lasers GmbH, 10623 Berlin (DE)
(72) Erfinder: Kropp, Jörg-Reinhardt, 12355 Berlin (DE)
(74) Vertreter: Fischer, Uwe

(57) **Zusammenfassung**

Die Erfindung bezieht sich u. a. auf ein Diodenlaserbauelement (10) mit einem Diodenlaserbarren (40), der mit seiner Barrenunterseite (41) auf einer Wärmesenke (20) angeordnet ist, mit einer oberen Elektrode (50), die die Barrenoberseite (42) des Diodenlaserbarrens (40) elektrisch kontaktiert, und mit einem oberen Kontaktkörper (60), der mit einem vorderen Teilstück (63) über der oberen Elektrode (50) und über dem Diodenlaserbarren (40) angeordnet ist und dort einen Abstand (A) zu der oberen Elektrode (50) aufweist und mit einem hinteren Teilstück (61) mit der oberen Elektrode (50) elektrisch in Verbindung steht.

Erfindungsgemäß ist vorgesehen, dass der Abstand (A) zwischen der oberen Elektrode (50) und dem vorderen Teilstück (63) des oberen Kontaktkörpers (60) mit einem flexiblen und wärmeleitfähigen Material (80) ausgefüllt ist und das flexible und wärmeleitfähige Material (80) einen Wärmefluss von der Barrenoberseite(42) des Diodenlaserbarrens (40) durch die obere Elektrode (50) und das flexible und wärmeleitfähige Material (80) hindurch zu dem vorderen Teilstück (63) des oberen Kontaktkörpers (60) ermöglicht. Die Wärmeabfuhr kann durch einen Wärmespreizer (30) aus CuW optimiert werden. Oberer und unterer Kontakt sind durch eine Kunststofffolie (70) voneinander elektrisch isoliert. Diese Anordnung ermöglicht eine beidseitige Wärmeabfuhr von der Laserdiode zu einer Wärmesenke (20) und verringert gleichzeitig thermische Spannungen zwischen der Laserdiode und der Halterung.

## Beschreibung

Die Erfindung bezieht sich auf ein Diodenlaserbauelement sowie ein Verfahren zum Herstellen eines Diodenlaserbauelements.

Ein Diodenlaserbauelement mit den Merkmalen gemäß dem Oberbegriff des Patentanspruchs 1 ist beispielsweise aus der deutschen Patentschrift DE 101 13 943 B4 bekannt. Dieses Diodenlaserbauelement weist einen Diodenlaserbarren auf, der mit seiner Barrenunterseite auf einer thermisch und elektrisch leitfähigen und eine untere Elektrode bildenden Wärmesenke angeordnet ist. Die Barrenoberseite des Diodenlaserbarrens wird elektrisch mit einer oberen Elektrode kontaktiert. Ein elektrischer Isolierkörper des Diodenlaserbauelements ist zwischen der oberen Elektrode und der Wärmesenke angeordnet und trennt diese elektrisch voneinander. Ein oberer Kontaktkörper ist mit einem vorderen Teilstück über dem Diodenlaserbarren angeordnet und weist dort einen Abstand zu der oberen Elektrode auf. In einem hinteren Teilstück steht der Kontaktkörper mit der oberen Elektrode mittelbar über ein oberes Zwischenplättchen elektrisch in Verbindung. Bei dem vorbekannten Diodenlaserbauelement erfolgt ein Ableiten von in dem Diodenlaserbarren während des Laserbetriebs erzeugter Abwärme über die Barrenunterseite in Richtung Wärmesenke.

Der Erfindung liegt die Aufgabe zugrunde, ein Diodenlaserbauelement anzugeben, das eine besonders gute Abfuhr von Abwärme ermöglicht.

Diese Aufgabe wird erfindungsgemäß durch ein Diodenlaserbauelement mit den Merkmalen gemäß Patentanspruch 1 gelöst. Vorteilhafte Ausgestaltungen des erfindungsgemäßen Diodenlaserbauelements sind in Unteransprüchen angegeben.

Danach ist erfindungsgemäß vorgesehen, dass der Abstand zwischen der oberen Elektrode und dem vorderen Teilstück des oberen Kontaktkörpers mit einem flexiblen und wärmeleitfähigen Material ausgefüllt ist und das flexible und wärmeleitfähige Material einen Wärmefluss von der Barrenoberseite des Diodenlaserbarrens durch die obere Elektrode und das flexible und wärmeleitfähige Material hindurch zu dem vorderen Teilstück des oberen Kontaktkörpers ermöglicht.

Ein wesentlicher Vorteil des erfindungsgemäßen Diodenlaserbauelements ist darin zu sehen, dass das erfindungsgemäß vorgesehene flexible und wärmeleitfähige bzw. wärmeleitende Material den Abstand zwischen der oberen Elektrode und dem vorderen Teilstück des oberen Kontaktkörpers überbrückt und zusätzlich einen Wärmeabfluss an der Barrenoberseite des Diodenlaserbarrens ermöglicht. Im Unterschied zu vorbekannten Diodenlaserbauelementen ist somit eine Wärmeabfuhr sowohl an der Barrenunterseite als auch an der Barrenoberseite möglich, wodurch die thermischen Eigenschaften des Diodenlaserbauelements deutlich verbessert werden.

Ein weiterer wesentlicher Vorteil des erfindungsgemäßen Diodenlaserbauelements besteht darin, dass trotz der zusätzlichen Wärmeabfuhr an der Barrenoberseite keine zusätzlichen mechanischen Spannungen in das Bauelement eingebracht werden, da das wärmeleitende Material erfindungsgemäß flexibel ist und somit mechanische Verspannungen aufnehmen bzw. kompensieren kann.

Bezüglich der Wärmeabfuhr wird es als vorteilhaft angesehen, wenn der obere Kontaktkörper Wärme, die von der Barrenoberseite des Diodenlaserbarrens - senkrecht zur Barrenoberseite nach oben - durch das flexible und wärmeleitende Material hindurch in den oberen Kontaktkörper geleitet wird, umlenkt und zu der darunterliegenden Wärmesenke abführt.

Mit Blick auf einen optimalen Wärmefluss vom oberen Kontaktkörper durch die Elektrode und den elektrischen Isolierkörper hindurch zur Wärmesenke wird es als vorteilhaft angesehen, wenn der obere Kontaktkörper in seinem hinteren Teilstück direkt stoffschlüssig mit der oberen Elektrode verbunden ist. Im Falle einer direkten stoffschlüssigen Verbindung zwischen Kontaktkörper und Elektrode lässt sich ein besonders geringer thermischer Widerstand an der Schnittstelle zwischen Kontaktkörper und Elektrode erreichen. Darüber hinaus wird auch ein minimaler elektrischer Kontaktwiderstand zwischen Kontaktkörper und Elektrode erzielt.

Vorzugsweise überdeckt das vordere Teilstück des oberen Kontaktkörpers den überwiegenden Teil der Barrenoberseite des Diodenlaserbarrens, um eine bestmögliche Wärmeabfuhr an der Barrenoberseite des Diodenlaserbarrens zu gewährleisten.

Mit Blick auf einen geringen thermischen Widerstand zwischen der oberen Elektrode und dem oberen Kontaktkörper bzw. mit Blick auf einen optimalen Wärmefluss von der Barrenoberseite des Diodenlaserbarrens in Richtung Kontaktkörper wird es als vorteilhaft angesehen, wenn der Abstand zwischen dem vorderen Teilstück und der oberen Elektrode maximal 100 µm beträgt. Bezüglich des flexiblen und wärmeleitenden Materials wird es als vorteilhaft angesehen, wenn dieses aus einer Paste, insbesondere Silicon-Paste, oder einem Gel besteht oder eine Paste oder Gel zumindest auch enthält. Die Paste und/oder das Gel enthält mit Blick auf die gewünschte Wärmeleitfähigkeit vorzugsweise Metalloxidpulver, Metallpulver, insbesondere Silberpulver, Glaspulver und/oder Keramikpulver. Als flexibles und wärmeleitendes Material kann insbesondere also auch ein Material verwendet werden, das neben einer thermischen Leitfähigkeit zusätzlich auch eine elektrische Leitfähigkeit aufweist. In Betracht kommen beispielsweise elastische Kleber mit darin enthaltenen Metallteilchen (z. B. mit darin enthaltenen Silberteilchen), die elektrisch und thermisch leitfähig sind. Geeignete Pasten oder Gele werden beispielsweise von der Firma Arctic Silver Incorporated, 9826 West Legacy Ave., Visalia, CA 93291, USA vertrieben.

Die obere Elektrode besteht vorzugsweise aus einem flachen, dünnen Blech mit einer Dicke von maximal 0,3 mm.

Mit Blick auf einen guten Wärmetransfer vom Kontaktkörper in Richtung Wärmesenke wird es als vorteilhaft angesehen, wenn ein zwischen der oberen Elektrode und der Wärmesenke angeordneter elektrischer Isolierkörper aus einer möglicht dünnen Materiallage mit einer Dicke von maximal 0,3 mm besteht.

Um thermische Spannungen an der Schnittstelle zwischen dem Diodenlaserbarren und der Wärmesenke zu vermeiden, wird es als vorteilhaft angesehen, wenn zwischen der Wärmesenke und dem Laserdiodenbarren ein Wärmespreizer angeordnet ist. Ein solcher Wärmespreizer besteht vorzugsweise aus einem Material, dessen thermischer Ausdehnungskoeffizient bestmöglich an den Ausdehnungskoeffizienten des Materials des Diodenlaserbarrens angepasst ist. In Betracht kommen beispielsweise Materialien wie Wolfram-Kupfer, Molybden-Kupfer, Berylliumoxid und Graphit.

Die Wärmesenke und der Wärmespreizer können separate aufeinandergesetzte Komponenten sein oder alternativ fest miteinander verbunden eine einzige Komponente bilden.

Mit Blick auf die Anordnung von elektrischem Isolierkörper und Wärmespreizer auf der Wärmesenke wird es als vorteilhaft angesehen, wenn der elektrische Isolierkörper und der Wärmespreizer überlappungsfrei, insbesondere neben- und/oder hintereinander, auf der Wärmesenke angeordnet sind.

Um einen geringen Kontaktwiderstand zwischen der oberen Elektrode und dem Diodenlaserbarren zu erhalten, wird es als vorteilhaft angesehen, wenn die obere Elektrode auf der Oberseite des Diodenlaserbarrens aufgelötet ist.

Im Übrigen wird es als vorteilhaft angesehen, wenn im Bereich des hinteren Teilstücks des oberen Kontaktkörpers der obere Kontaktkörper auf die obere Elektrode und die obere Elektrode auf den elektrischen Isolierkörper aufgedrückt wird, insbesondere mittels der Andrückkraft einer Schraubverbindung.

Die Wärmesenke, die obere Elektrode sowie der obere Kontaktkörper bestehen vorzugsweise jeweils aus einem elektrisch leitenden und wärmeleitfähigen Material. Kupfer und Kupferlegierungen werden als besonders geeignet angesehen.

Mit Blick auf möglichst niedrige elektrische und thermische Kontaktwiderstände wird es als vorteilhaft angesehen, wenn der obere Kontaktkörper und die Wärmesenke miteinander unter Bildung einer Anpresskraft verschraubt sind. Als besonders vorteilhaft wird es angesehen, wenn die obere Elektrode zumindest eine Ausnehmung aufweist, durch die zumindest eine Schraube hindurchgeführt ist, die den oberen Kontaktkörper mit der Wärmesenke verschraubt und eine mechanischen Andruckkraft erzeugt, die den oberen Kontaktkörper auf die obere Elektrode, die obere Elektrode auf den elektrischen Isolierkörper und den elektrischen Isolierkörper auf die Wärmesenke drückt. Mit Schrauben lassen sich in besonders einfacher Weise hohe mechanische Andrückkräfte erzeugen.

Die Erfindung bezieht sich darüber hinaus auf ein Verfahren zum Herstellen eines Diodenlaserbauelements, bei dem ein Diodenlaserbarren mit seiner Barrenunterseite auf einer Wärmesenke aufgebracht wird, mit einer oberen Elektrode die Barrenoberseite des Diodenlaserbarrens elektrisch kontaktiert wird und ein oberer Kontaktkörper oberhalb der oberen Elektrode montiert wird, und zwar derart, dass der obere Kontaktkörper mit einem über dem Diodenlaserbarren befindlichen vorderen Teilstück einen Abstand zu der oberen Elektrode aufweist.

Erfindungsgemäß ist vorgesehen, dass im Bereich der Barrenoberseite des Diodenlaserbarrens die obere Elektrode mit einem flexiblen und wärmeleitenden Material versehen wird, das den Abstand zwischen der oberen Elektrode und dem vorderen Teilstück des oberen Kontaktkörpers ausfüllt und einen Wärmefluss von der Barrenoberseite des Diodenlaserbarrens durch die obere Elektrode und das flexible und wärmeleitende Material hindurch zu dem oberen Kontaktkörper ermöglicht.

Bezüglich der Vorteile des erfindungsgemäßen Verfahrens sei auf die obigen Ausführungen im Zusammenhang mit dem erfindungsgemäßen Diodenlaserbauelement verwiesen, da die Vorteile des erfindungsgemäßen Diodenlaserbauelements denen des erfindungsgemäßen Verfahrens im Wesentlichen entsprechen.

Die Erfindung wird nachfolgend anhand von Ausführungsbeispielen näher erläutert; dabei zeigen beispielhaft
- Figur 1: ein erstes Ausführungsbeispiel für ein erfindungsgemäßes Diodenlaserbauelement in einer dreidimensionalen Sicht schräg von der Seite,
- Figur 2: das Diodenlaserbauelement gemäß Figur 1 in schematischer Darstellung im Querschnitt und
- Figur 3: das Diodenlaserbauelement gemäß den Figuren 1 und 2 in einer weiteren dreidimensionalen Darstellung schräg von der Seite.

In den Figuren werden der Übersicht halber für identische oder vergleichbare Komponenten dieselben Bezugszeichen verwendet.

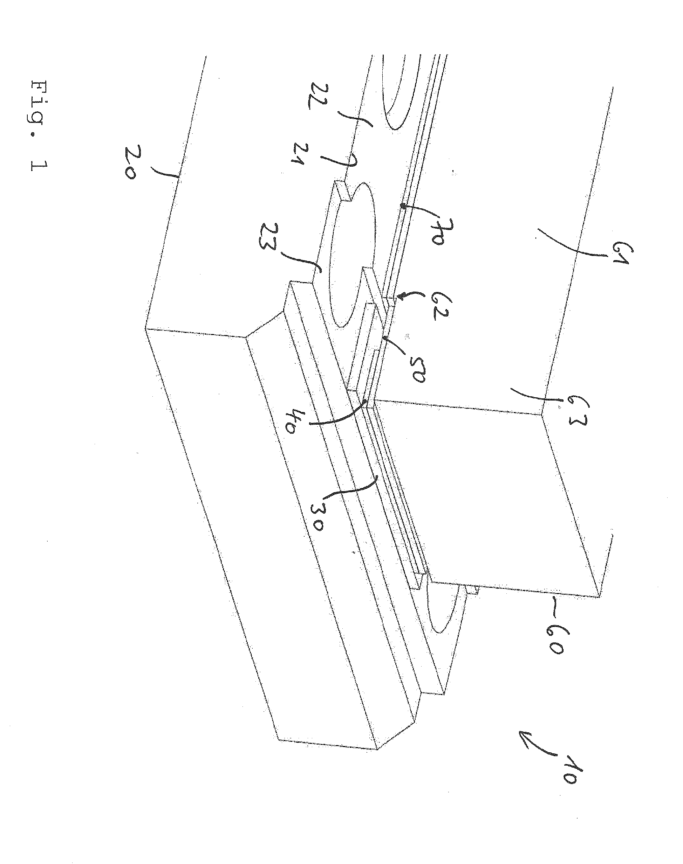

Die Figur 1 zeigt ein Ausführungsbeispiel für ein Diodenlaserbauelement 10, bei dem eine Wärmesenke 20 ein mechanisches Trägerelement sowie eine untere elektrische Elektrode für das Diodenlaserbauelement 10 bildet. Die Wärmesenke 20 kann beispielsweise aus Kupfer, Kupfer-Wolfram oder Kupfer-Molybdäm bestehen.

In der Figur 1 lässt sich erkennen, dass die Oberfläche 21 der Wärmesenke 20 gestuft ausgeführt ist, so dass die Wärmesenke 20 ein höher liegendes, hinteres Teilstück 22 sowie ein tiefer liegendes, vorderes Teilstück 23 umfasst. Im Bereich des vorderen Teilstücks 23 der Wärmesenke 20 ist ein Wärmespreizer 30 angeordnet, auf dem sich ein Diodenlaserbarren 40 befindet. Der Diodenlaserbarren 40 ist deutlich breiter als hoch; er kann beispielsweise eine Dicke von lediglich 100 µm und eine Länge von über 10 mm aufweisen. Der Diodenlaserbarren 40 umfasst eine oder mehrere Laserdioden, die bei Stromfluss - bei dem Ausführungsbeispiel und der Darstellung gemäß Figur 1 in vertikaler Richtung - Laserlicht erzeugen können. Der Diodenlaserbarren 40 besteht vorzugsweise aus halbleitendem Material, beispielsweise auf der Basis von GaAs oder dergleichen. Der Diodenlaserbarren 40 wird vorzugsweise so montiert, dass der laseraktive Bereich unten bzw. möglichst dicht am Wärmespreizer 30 liegt, um eine optimale Wärmeableitung zu erreichen.

Der Diodenlaserbarren 40 ist vorzugsweise mit dem Wärmespreizer 30 fest verbunden, beispielsweise durch ein ganzflächiges Auflöten der Barrenunterseite des Diodenlaserbarrens 40 auf der Oberseite des Wärmespreizers 30, um einen geringen elektrischen und thermischen Kontaktwiderstand zu erreichen. Die Unterseite des Wärmespreizers 30 ist vorzugsweise ebenfalls fest auf dem vorderen Teilstück 23 der Wärmesenke 20 angebracht, beispielsweise ebenfalls mit Hilfe einer Lötverbindung.

Die Funktion des Wärmespreizers 30 besteht darin, mechanische Spannungen im Bereich des Diodenlaserbarrens 40 zu vermeiden oder zumindest zu reduzieren. Üblicherweise wird das Material der Wärmesenke 20 einen anderen thermischen Ausdehnungskoeffizienten als das Material des Diodenlaserbarrens 40 aufweisen, so dass bei Erwärmung des Diodenlaserbarrens 40 während des Laserbetriebs mechanische Spannungen unvermeidbar sind. Um diese mechanische Spannungen nicht an der Schnittstelle zum Diodenlaserbarren 40 auftreten zu lassen, ist der thermische Ausdehnungskoeffizient des Wärmespreizers 30 vorzugsweise an den thermischen Ausdehnungskoeffizienten des Diodenlaserbarrens 40 angepasst, so dass die auftretenden mechanischen Spannungen durch den Wärmespreizer 30 an die Schnittstelle zwischen dem Wärmespreizer 30 und der Wärmesenke 20 verschoben werden und die Schnittstelle zwischen dem Wärmespreizer 30 und dem Diodenlaserbarren 40 spannungsfrei oder zumindest spannungsarm bleibt. Der Wärmespreizer 30 kann beispielsweise aus Wolfram-Kupfer, Molybden-Kupfer, Berylliumoxid, Graphit oder anderen leitfähigen Materialien bestehen.

Während die elektrische Kontaktierung des Diodenlaserbarrens 40 auf der Barrenunterseite durch den Wärmespreizer 30 sowie die Wärmesenke 20 erfolgt, dient zur elektrischen Kontaktierung der Barrenoberseite des Diodenlaserbarrens 40 eine obere Elektrode 50, bei der es sich vorzugweise um ein dünnes Blech aus einem elektrisch hochleitfähigen Material, beispielsweise um ein dünnes Kupferblech, handelt. Die Dicke der oberen Elektrode beträgt vorzugsweise maximal 0,3 mm.

Die obere Elektrode 50 steht mit einem hinteren Teilstück 61 eines oberen thermisch leitfähigen Kontaktkörpers 60 in Kontakt. Vorzugsweise ist die obere Elektrode 50 mit dem hinteren Teilstück 61 des oberen Kontaktkörpers 60 fest verbunden, beispielsweise an diesem angelötet. Alternativ kann die Verbindung zwischen dem hinteren Teilstück 61 des Kontaktkörpers 60 und der oberen Elektrode 50 auch auf einer Andrückverbindung bzw. einer Andrückkraft beruhen, die durch eine Verschraubung oder dergleichen hervorgerufen wird.

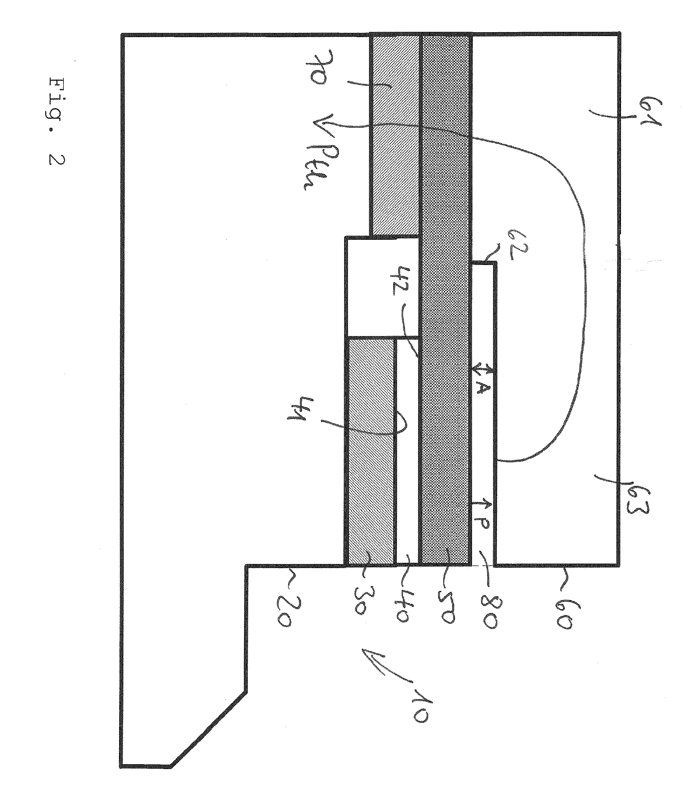

In der Figur 1 lässt sich außerdem erkennen, dass die Unterseite des oberen Kontaktkörpers 60 mit einer Stufe 62 versehen ist, die das hintere Teilstück 61 des oberen Kontaktkörpers 60 von einem vorderen Teilstück 63 trennt. Aufgrund der Stufe 62 kommt es zu einem vertikalen Abstand zwischen der oberen Elektrode 50 und dem vorderen Teilstück 63, wie weiter unten im Zusammenhang mit der Figur 2 noch näher erläutert werden wird.

Die Figur 1 zeigt darüber hinaus einen elektrischen Isolierkörper 70 (zum Beispiel in Form einer nichtleitenden Kunststoffplatte oder Kaptonfolie), der die obere Elektrode 50 von der als untere Elektrode arbeitenden Wärmesenke 20 elektrisch trennt. Werden die obere Elektrode 50 und die Wärmesenke 20 mit einer elektrischen Spannung beaufschlagt, so wird der resultierende Stromfluss somit den im vorderen Teilstück 63 des Kontaktkörpers 60 befindlichen Bereich der oberen Elektrode 50 passieren und durch den Diodenlaserbarren 40 in vertikaler Richtung hindurchfließen müssen.

Die Figur 2 zeigt das Diodenlaserbauelement 10 gemäß Figur 1 im Querschnitt. Es lässt sich erkennen, dass die Barrenunterseite 41 des Diodenlaserbarrens 40 auf dem Wärmespreizer 30 angebracht, beispielsweise auf diesem aufgelötet, ist. Darüber hinaus lässt sich erkennen, dass die Barrenoberseite 42 des Diodenlaserbarrens 40 mit der oberen Elektrode 50 in Kontakt steht.

Die Figur 2 zeigt darüber hinaus die Wirkung der Stufe 62, die das hintere Teilstück 61 des Kontaktkörpers 60 von dem vorderen Teilstück 63 trennt und zu einem räumlichen Abstand A zwischen der oberen Elektrode 50 und dem vorderen Teilstück 63 des Kontaktkörpers 60 führt.

Um nun während des Betriebs des Diodenlaserbarrens 40 eine optimale Wärmeabfuhr zu ermöglichen und zu erreichen, dass die im Diodenlaserbarren 40 freiwerdende Wärme nicht nur über die Barrenunterseite 41 zur Wärmesenke 20 gelangen kann, ist der Bereich zwischen der oberen Elektrode 50 und dem vorderen Teilstück 63 des Kontaktkörpers 60 mit einem flexiblen wärmeleitfähigen Material 80 gefüllt, bei dem es sich beispielsweise um eine Vergussmasse aus thermisch leitfähigem Gummi und/oder eine Vergussmasse aus thermisch leitfähigem Kunststoff handeln kann. Das flexible wärmeleitfähige Material 80 schließt den Spalt bzw. den Abstand A zwischen der oberen Elektrode 50 und dem Kontaktkörper 60 und führt dazu, dass die in dem Diodenlaserbarren 40 erzeugte Wärme über die Barrenoberseite 42 - und zwar senkrecht zur Barrenoberseite 42 bzw. bei der Darstellung gemäß Figur 2 nach oben - durch die obere Elektrode 50 sowie das flexible wärmeleitfähige Material 80 hindurch entlang der Pfeilrichtung P in das vordere Teilstück 63 des Kontaktkörpers 60 gelangen kann.

Mit anderen Worten wird der obere Kontaktkörper 60 aufgrund der Wärmeleitfähigkeit des flexiblen wärmeleitfähigen Materials 80 zu einem Hilfskühlkörper, der die an der Barrenoberseite 42 des Diodenlaserbarrens 40 abgegebene Abwärme Pth aufnimmt, umlenkt und im Bereich des hinteren Teilstücks 61 des Kontaktkörpers 60 über die Elektrode 50 sowie den elektrischen Isolierkörper 70 in das unter dem hinteren Teilstück 61 des Kontaktkörpers 60 befindliche hintere Teilstück 22 der Wärmesenke 20 einspeist. Das Umlenken der Abwärme Pth durch den Kontaktkörper 60 erfolgt vorzugsweise um einen Umlenkwinkel im Bereich zwischen 90° und 270°, beispielsweise um einen Umlenkwinkel von 180°.

Um eine besonders effiziente Wärmeabfuhr über die Barrenoberseite 42 zu erreichen, ist die Größe des Spalts bzw. der Abstand A zwischen der Elektrode 50 und dem vorderen Teilstück 63 des Kontaktkörpers 60 vorzugsweise kleiner als 100 µm.

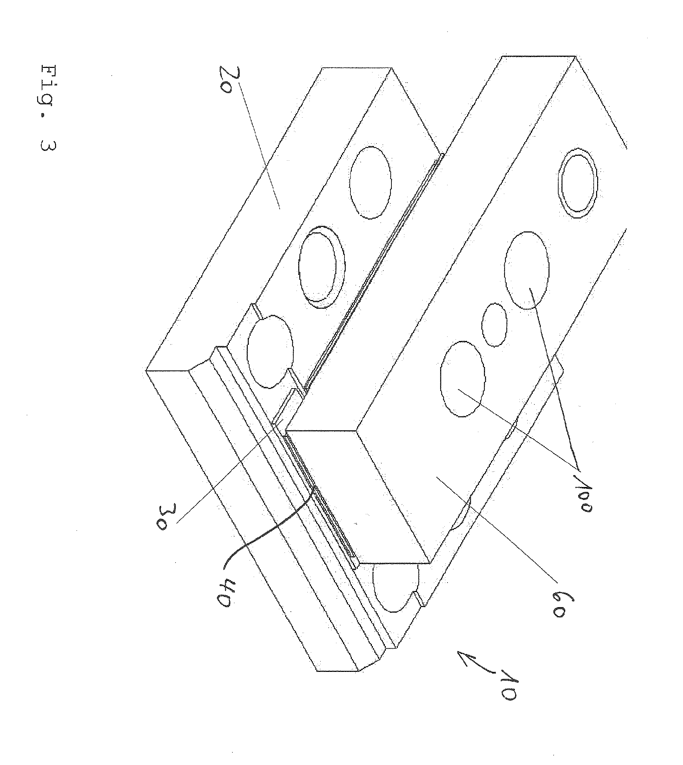

Die Figur 3 zeigt das Diodenlaserbauelement 10 gemäß den Figuren 1 und 2 nochmals in einer dreidimensionalen Sicht schräg von der Seite. Es lassen sich in der Figur 3 zusätzlich Ausnehmungen 100 erkennen, die ein Durchführen von Schrauben ermöglichen, mit denen sich der Kontaktkörper 60 auf der Wärmesenke 20 aufschrauben lässt und eine Pressverbindung zwischen dem Kontaktkörper 60 und der Wärmesenke 20 erzeugt werden kann. Derartige Schrauben werden vorzugsweise durch elektrische Isolierelemente, wie beispielsweise isolierende Scheiben oder Hülsen, elektrisch von dem oberen Kontaktkörper 60 getrennt. Mit einer Pressverbindung lässt sich u. a. die Elektrode 50 (vgl. Figur 2) auf die Barrenoberseite 42 des Diodenlaserbarrens 40 drücken und eine optimale Kontaktierung des Diodenlaserbarrens 40 erreichen. Gleichzeitig wird über das ebenfalls eingeklemmte flexible wärmeleitfähige Material 80 eine Wärmeabfuhr in Richtung des oberen Kontaktkörpers 60 ermöglicht, ohne dass es zu mechanischen Spannungen im Bereich der Barrenoberseite 42 des Diodenlaserbarrens 40 kommt, weil das wärmeleitfähige Material 80 flexibel ist.

Das Füllen des Spalts bzw. des Abstands A (vgl. Figur 2) zwischen der oberen Elektrode 50 und dem vorderen Teilstück 63 des Kontaktkörpers 50 erfolgt vorzugsweise durch ein Einfüllen bzw. Eingießen einer Vergussmasse aus einem thermisch leitfähigen Gummi und/oder einem thermisch leitfähigen Kunststoff, vor, während oder nachdem der Kontaktkörper 60 mit der Wärmesenke 20 verschraubt worden ist. Alternativ kann auch eine flexible Materiallage aus thermisch leitfähigem Material 80 auf die obere Elektrode aufgelegt werden, bevor der obere Kontaktkörper 60 und die Wärmesenke 20 miteinander verschraubt und aufeinander gepresst werden.

Bei dem Ausführungsbeispiel gemäß den Figuren 1 und 2 hat das flexible wärmeleitfähige Material 80 eine Doppelfunktion: Zum einen ermöglicht das flexible wärmeleitfähige Material 80 einen Wärmeübergang in senkrechter Richtung von der Barrenoberseite 42 des Diodenlaserbarrens 40 (vgl. Figur 2) in Richtung des oberen Kontaktkörpers 60, so dass dieser nach einem Umlenken des Wärmeflusses die Abwärme zu der darunter liegenden Wärmesenke 20 weiterleiten kann; und zum anderen vermeidet das flexible wärmeleitfähige Material 80 ein Auftreten mechanischer Spannungen zwischen der oberen Elektrode 50 und dem Kontaktkörper 60, weil das Material 80 flexibel ist.

Bei dem Ausführungsbeispiel gemäß den Figuren 1 bis 3 beruht der Spalt bzw. der Abstand A zwischen der oberen Elektrode 50 und dem oberen Kontaktkörper 60 auf der Stufe 62 im Kontaktkörper 60. Auch andere Ausgestaltungen sind möglich, um den Abstand A hervorzurufen und Platz für das flexible wärmeleitfähige Material 80 zwischen der Elektrode 50 und dem Kontaktkörper 60 zu schaffen. So kann beispielsweise - im Falle eines Kontaktkörpers 60 ohne Stufe 62 - die Dicke der Elektrode 50 ortsabhängig sein und im Bereich des hinteren Teilstücks des Kontaktkörpers 60 dicker als im Bereich des vorderen Teilstücks sein, so dass der Abstand A durch die Ausgestaltung der Elektrode 50 hervorgerufen wird. Beispielsweise kann die Elektrode 50 im Bereich des hinteren Teilstücks 61 des Kontaktkörpers 60 durch eine Blechdoppellage und im Bereich des vorderen Teilstücks 63 durch eine einzige Blechlage gebildet sein.

Die Erfindung wurde zwar im Detail durch bevorzugte Ausführungsbeispiele näher gezeigt und beschrieben, jedoch ist die Erfindung nicht durch die offenbarten Beispiele eingeschränkt. Andere Variationen können daraus vom Fachmann abgeleitet werden, ohne den Schutzumfang der Erfindung zu verlassen.

**Bezugszeichenliste**

| | |
|---|---|
| 10 | Diodenlaserbauelement |
| 20 | Wärmesenke |
| 21 | Oberfläche |
| 22 | hinteres Teilstück |
| 23 | vorderes Teilstück |
| 30 | Wärmespreizer |
| 40 | Diodenlaserbarren |
| 41 | Barrenunterseite |
| 42 | Barrenoberseite |
| 50 | obere Elektrode |
| 60 | oberer Kontaktkörper |
| 61 | hinteres Teilstück |
| 62 | Stufe |
| 63 | vorderes Teilstück |
| 70 | Isolierkörper |
| 80 | wärmeleitfähiges Material |
| 100 | Ausnehmung |
| A | Abstand |
| P | Pfeilrichtung |
| Pth | Abwärme |

## Patentansprüche

1. Diodenlaserbauelement (10) mit
- einem Diodenlaserbarren (40), der mit seiner Barrenunterseite (41) auf einer Wärmesenke (20) angeordnet ist,
- mit einer oberen Elektrode (50), die die Barrenoberseite (42) des Diodenlaserbarrens (40) elektrisch kontaktiert, und
- mit einem oberen Kontaktkörper (60), der mit einem vorderen Teilstück (63) über der oberen Elektrode (50) und über dem Diodenlaserbarren (40) angeordnet ist und dort einen Abstand (A) zu der oberen Elektrode (50) aufweist und mit einem hinteren Teilstück (61) mit der oberen Elektrode (50) elektrisch in Verbindung steht,
**dadurch gekennzeichnet, dass**
der Abstand (A) zwischen der oberen Elektrode (50) und dem vorderen Teilstück (63) des oberen Kontaktkörpers (60) mit einem flexiblen und wärmeleitfähigen Material (80) ausgefüllt ist und das flexible und wärmeleitfähige Material (80) einen Wärmefluss von der Barrenoberseite (42) des Diodenlaserbarrens (40) durch die obere Elektrode (50) und das flexible und wärmeleitfähige Material (80) hindurch zu dem vorderen Teilstück (63) des oberen Kontaktkörpers (60) ermöglicht.

2. Diodenlaserbauelement (10) nach Anspruch 1,
**dadurch gekennzeichnet, dass**
der obere Kontaktkörper (60) Wärme, die von der Barrenoberseite (42) des Diodenlaserbarrens(40) durch das flexible und wärmeleitfähige Material (80) hindurch in den oberen Kontaktkörper (60) geleitet wird, umlenkt und zu der darunterliegenden Wärmesenke (20) abführt.

3. Diodenlaserbauelement (10) nach einem der voranstehenden Ansprüche,
**dadurch gekennzeichnet, dass**
der obere Kontaktkörper (60) in seinem hinteren Teilstück (61) direkt stoffschlüssig mit der oberen Elektrode (50) verbunden ist.

4. Diodenlaserbauelement (10) nach einem der voranstehenden Ansprüche,
**dadurch gekennzeichnet, dass**
das flexible und wärmeleitfähige Material (80) aus einer Paste, insbesondere Silicon-Paste, einem Kleber oder einem Gel besteht, wobei die Paste, der Kleber oder das Gel Metalloxidpulver, Metallpulver, insbesondere Silberpulver, Glaspulver und/oder Keramikpulver enthält.

5. Diodenlaserbauelement (10) nach einem der voranstehenden Ansprüche,
**dadurch gekennzeichnet, dass**
die obere Elektrode (50) aus einem flachen, dünnen Blech mit einer Dicke von maximal 0,3 mm besteht.

6. Diodenlaserbauelement (10) nach einem der voranstehenden Ansprüche,
**dadurch gekennzeichnet, dass**
zwischen der oberen Elektrode (50) und der Wärmesenke (20) ein elektrischer Isolierkörper (70) angeordnet ist, der eine Dicke von maximal 0,3 mm aufweist.

7. Diodenlaserbauelement (10) nach einem der voranstehenden Ansprüche,
**dadurch gekennzeichnet, dass**
ein Wärmespreizer (30) zwischen der Wärmesenke (20) und dem Diodenlaserbarren (40) angeordnet ist.

8. Diodenlaserbauelement (10) nach einem der voranstehenden Ansprüche,
**dadurch gekennzeichnet, dass**
der elektrische Isolierkörper (70) und der Wärmespreizer (30) überlappungsfrei, insbesondere neben- und/oder hintereinander, auf der Wärmesenke (20) angeordnet sind.

9. Diodenlaserbauelement (10) nach einem der voranstehenden Ansprüche,
**dadurch gekennzeichnet, dass**
das vordere Teilstück (63) des Kontaktkörpers (60) mindestens die Breite des Diodenlaserbarrens (40) aufweist.

10. Diodenlaserbauelement (10) nach einem der voranstehenden Ansprüche,
**dadurch gekennzeichnet, dass**
die obere Elektrode (50) auf der Oberseite (42) des Diodenlaserbarrens (40) aufgelötet ist.

11. Diodenlaserbauelement (10) nach einem der voranstehenden Ansprüche 1-9,
**dadurch gekennzeichnet, dass**
im Bereich des hinteren Teilstücks (61) des oberen Kontaktkörpers (60) der obere Kontaktkörper (60) auf die obere Elektrode (50) und die obere Elektrode (50) auf den elektrischen Isolierkörper (70) aufgedrückt wird, insbesondere mittels der Andrückkraft einer Schraubverbindung.

12. Diodenlaserbauelement (10) nach einem der voranstehenden Ansprüche,
**dadurch gekennzeichnet, dass**
die Wärmesenke (20), die obere Elektrode (50) sowie der obere Kontaktkörper (60) jeweils aus einem elektrisch und wärmeleitfähigen Material (80), insbesondere aus Kupfer, bestehen.

13. Diodenlaserbauelement (10) nach einem der voranstehenden Ansprüche,
**dadurch gekennzeichnet, dass**
die obere Elektrode (50) zumindest eine Ausnehmung (100) aufweist, durch die zumindest eine Schraube hindurchgeführt ist, die den oberen Kontaktkörper (60) mit der Wärmesenke (20) verschraubt und eine mechanischen Andruckkraft erzeugt, die den oberen Kontaktkörper (60) auf die obere Elektrode (50), die obere Elektrode (50) auf den elektrischen Isolierkörper (70) und den elektrischen Isolierkörper (70) auf die Wärmesenke (20) drückt.

14. Verfahren zum Herstellen eines Diodenlaserbauelements (10), bei dem
- ein Diodenlaserbarren (40) mit seiner Barrenunterseite (41) auf einer Wärmesenke (20) aufgebracht wird,
- mit einer oberen Elektrode (50) die Barrenoberseite (42) des Diodenlaserbarrens (40) elektrisch kontaktiert wird und
- ein oberer Kontaktkörper (60) oberhalb der oberen Elektrode (50) montiert wird, und zwar derart, dass der obere Kontaktkörper (60) mit einem über dem Diodenlaserbarren (40) befindlichen vorderen Teilstück (63) einen Abstand (A) zu der oberen Elektrode (50) aufweist,
**dadurch gekennzeichnet, dass**
im Bereich der Barrenoberseite (42) des Diodenlaserbarrens (40) die obere Elektrode (50) mit einem flexiblen und wärmeleitfähigen Material (80) versehen wird, das den Abstand (A) zwischen der oberen Elektrode (50) und dem vorderen Teilstück (63) des oberen Kontaktkörpers (60) ausfüllt und einen Wärmefluss von der Barrenoberseite (42) des Diodenlaserbarrens (40) durch die obere Elektrode (50) und das flexible und wärmeleitfähige Material (80) hindurch zu dem oberen Kontaktkörper (60) ermöglicht.
